# EUROPEAN PATENT APPLICATION

(11) **EP 4 539 341 A1**
(43) Date of publication of application: **16.04.2025**
(21) Application number: 23202438.0
(22) Date of filing: 09.10.2023
(51) Int. Cl.: H03M 7/26, H03M 7/30, H03M 7/40, H03M 7/24

(54) **ENCODED DATA STRUCTURE FOR UNCERTAINTY DISTRIBUTIONS**

(71) Applicant: Signaloid Limited, Cambridge Cambridgeshire CB1 2GE (GB)
(72) Inventor: Bilgin, Bilgesu, Cambridge (GB); Tsoutsouras, Vasileios, Cambridge (GB); Kaparounakis, Orestis, Cambridge (GB); Sarson, Harry, Cambridge (GB); Stanley-Marbell, Phillip, Cambridge (GB)
(74) Representative: Legl, Stefan

(57) **Abstract**

The present disclosure relates to a computer-accessible medium having stored an encoded data structure, the encoded data structure comprising a plurality of data elements encoding a representation of uncertainty distribution information of a data set, and at least a part of decoding information for decoding the encoded representation.

## Description

### FIELD

The present disclosure relates to a computer-accessible medium having stored an encoded data structure, a computer-implemented method for generating an encoded data structure, a data processing system for generating an encoded data structure, a computer-implemented method for decoding an encoded data structure, a data processing system for decoding an encoded data structure, computer programs carrying out the methods, and computer-readable storage media comprising instructions for carrying out the methods. More particularly, the present disclosure relates to a data format for encoding uncertainty information.

### BACKGROUND

Nowadays, computers are used for data processing in almost every aspect of life. Data that can be processed by computers may include, but are not limited to, readings from sensors, stock market data, or measurements of the output of a quantum computer. While uncertainties in such data are commonplace, conventional computing platforms can only deal with integer and floating-point values which are certain and unambiguous. Therefore, conventional computing platforms often attempt to eliminate the uncertainties by averaging the variations across readings into a single number so that operations such as ADD, SUBSTRACT, MULTIPLY, XOR, etc. can be performed on these data. The results of these operations are other integers or floating-point values.

In many use cases, the accuracy of the processing results is critical. For example, the sensor data feeding an autonomous control algorithm of a self-driving car contains variations across the vehicle's sensors. The quality of the autonomous control algorithm's decision making may depend on the accuracy of the processing results. For example, if the autonomous control algorithm must perform an emergency stop, the uncertainties in the sensor data may affect whether the emergency stop is performed in a safe manner.

In such safety-critical use cases, so-called Monte Carlo methods can be employed, which involve re-running software millions of times with slightly different inputs, according to the distributions of the input uncertainties, to understand how uncertainties in the inputs could affect results. Because computers today can only perform calculations on numbers as opposed to being able to perform calculations on uncertainty distributions, Monte Carlo methods are slow and expensive and only feasible for use in offline analyses.

### SUMMARY

In light of the above, a computer-accessible medium having stored an encoded data structure, a computer-implemented method for generating an encoded data structure, a data processing system for generating an encoded data structure, a computer-implemented method for decoding an encoded data structure, a data processing system for decoding an encoded data structure, computer programs carrying out the methods, and computer-readable storage media comprising instructions for carrying out the methods are provided.

It is an object of the present disclosure to be able to perform calculations on uncertainty distributions. Another object of the present disclosure is to minimize the time and resources required for calculations on uncertainty distributions.

The objects are solved by the features of the independent claims. Preferred embodiments are defined in the dependent claims.

According to an independent aspect of the present disclosure, a computer-accessible medium having stored an encoded data structure is provided. The encoded data structure includes a plurality of data elements encoding a representation of uncertainty distribution information of a data set.

According to some embodiments, which can be combined with other embodiments described herein, the uncertainty distribution information includes, or relates to, a probability distribution. A probability distribution is generally understood as a phenomenon in terms of its sample space and the probabilities of events.

According to some embodiments, which can be combined with other embodiments described herein, the encoded data structure further includes at least a part of decoding information for decoding the encoded representation.

Preferably, the decoding information for decoding the encoded representation is encoded in the plurality of data elements. Additionally, or alternatively, at least a part of the decoding information is provided separately from the plurality of data elements, e.g., in one or more additional fields of the encoded data structure. The decoding information provided separately from the plurality of data elements may include, or be, the auxiliary information described later.

According to some embodiments, which can be combined with other embodiments described herein, the encoded data structure further includes a numerical prefix.

Preferably, the numerical prefix is a particle value.

According to some embodiments, which can be combined with other embodiments described herein, the encoded data structure further includes a separator preceding the plurality of data elements.

Preferably, the separator separates the plurality of data elements from the numerical prefix.

Preferably, the separator is a non-numeric separator.

Preferably, the separator represents "Ux".

According to some embodiments, which can be combined with other embodiments described herein, the encoded data structure further includes representation type information. The representation type information can be considered decoding information for decoding the encoded representation but is not limited thereto.

According to some embodiments, which can be combined with other embodiments described herein, the encoded data structure further includes auxiliary information related to the representation. The auxiliary information can be considered decoding information for decoding the encoded representation but is not limited thereto.

Preferably, the auxiliary information includes at least one of a number of samples (from which the distribution was generated), a mean value of distribution, and a number of non-zero mass Dirac deltas.

Preferably, the auxiliary information includes information about at least one algorithm used to generate the encoded data structure. For example, the at least one algorithm used to generate the encoded data structure may be an algorithm configured to transform the uncertainty representation into the Ux Data.

Preferably, the auxiliary information includes information about at least one algorithm used to generate the representation. In particular, the at least one algorithm used to generate the representation may be an algorithm configured to transform the data set into the uncertainty representation. In some embodiments, the at least one algorithm used to generate the representation may be a distribution-to-Telescoping Torques Representation (TTR) conversion algorithm.

Preferably, the auxiliary information includes information about at least one decoding algorithm to be used to decode the encoded data structure. In particular, the at least one algorithm to be used to decode the encoded data structure may be an algorithm configured to transform the plurality of data elements into the uncertainty representation. In some embodiments, the at least one algorithm to be used to decode the encoded data structure may be a Telescoping Torques Representation (TTR)-to-distribution conversion algorithm.

Preferably, the auxiliary information includes one or more of a version number, a potentially unique identifier, summary statistics about the distribution, information relating to the correlation between the represented distribution and other encoded data structures, and possibly other metadata.

According to some embodiments, which can be combined with other embodiments described herein, the plurality of data elements encodes a set of tuples defining the representation.

Preferably, each tuple consists of a real value paired with a probability associated with the real value.

Preferably, the real value of a tuple indicates a position of a non-zero mass Dirac delta, and the probability is a probability mass corresponding to the non-zero mass Dirac delta of the tuple.

According to some embodiments, which can be combined with other embodiments described herein, at least the plurality of data elements is in the form of a hexadecimal string ("Ux String").

According to some embodiments, which can be combined with other embodiments described herein, the encoded data structure is in binary form ("Ux Binary").

According to some embodiments, which can be combined with other embodiments described herein, the encoded data structure is included in a file.

Preferably, the file includes a main body containing the numerical prefix and a table or index indicating which byte offset in the main body the entry is referring to, followed by the plurality of data elements.

Preferably, the table or index is at the end of the file.

Preferably, the plurality of data elements in the file is provided in a binary form or as a hexadecimal string.

According to some embodiments, which can be combined with other embodiments described herein, information about the offset is stored in an operating system's metadata to reference the plurality of data elements, i.e., the uncertainty information, in the file.

According to some embodiments, which can be combined with other embodiments described herein, the computer-accessible medium is selected from the group including, or consisting of, a non-transitory computer-readable storage (or memory) medium and an electronic message.

Preferably, the computer-accessible medium is a non-transitory computer-readable storage (or memory) medium. The term "non-transitory computer-readable storage (or memory) medium" includes, but is not limited to, magnetic or optical media, e.g., disks, hard drives, or DVDs/CD-ROMs, volatile or non-volatile media such as RAM (e.g., SDRAM, DDR, RDRAM, SRAM, etc.), ROM, etc. The non-transitory computer-readable storage (or memory) medium may include other types of non-transitory memory as well or combinations thereof.

Preferably, the computer-accessible medium is an electronic message. The term "electronic message" refers to transmission media or signals such as electrical, electromagnetic, or digital signals, conveyed via a communication medium such as a network and/or a wireless link.

According to another independent aspect of the present disclosure, a computer-implemented method for generating an encoded data structure is provided. The method includes applying an encoding algorithm to generate an encoded data structure based on a data set including uncertainty distribution information, and outputting the encoded data structure. The encoded data structure includes a plurality of data elements encoding a representation of the uncertainty distribution information of the data set.

Preferably, the encoded data structure further includes at least a part of decoding information for decoding the encoded representation.

According to some embodiments, which can be combined with other embodiments described herein, the data set includes, or is, a set of empirical samples or an analytic distribution.

According to some embodiments, which can be combined with other embodiments described herein, the data set includes, or is, a set of sensor readings.

According to some embodiments, which can be combined with other embodiments described herein, the method further includes applying a representation generation algorithm to generate the representation of the uncertainty distribution information from the data set.

Preferably, the representation generation algorithm is configured to generate the representation according to a position parameter and a probability parameter.

Preferably, the representation generation algorithm is configured to generate the representation as a sum-of-Dirac-deltas representation, where each position of the representation is represented by a non-zero mass Dirac delta associated with a corresponding probability mass.

According to some embodiments, which can be combined with other embodiments described herein, the representation generation algorithm includes, or is, a recursive conversion algorithm of *log₂ N* steps, where *N* is a size of the representation.

According to some embodiments, which can be combined with other embodiments described herein, the method further includes generating a set of tuples defining the uncertainty representation.

Preferably, the set of tuples is a set of *k*-tuples, *k* being a positive integer ≥ 2.

Preferably, the set of tuples is a set of 2-tuples (*k*=2), each 2-tuple consisting of a real value and a probability associated with the real value, wherein the set of tuples is encoded in the plurality of data elements.

Preferably, the real value of a tuple indicates a position of a non-zero mass Dirac delta, and the probability is a probability mass corresponding to the non-zero mass Dirac delta of the tuple.

Preferably, the probabilities in the set of tuples add up to 1.

According to some embodiments, which can be combined with other embodiments described herein, the encoded data structure is configured according to the embodiments described in this document.

According to another independent aspect of the present disclosure, a data processing system for generating an encoded data structure is provided. The data processing system includes one or more processors configured to apply an encoding algorithm to generate an encoded data structure based on a data set including uncertainty distribution information, the encoded data structure including a plurality of data elements encoding a representation of the uncertainty distribution information of the data set, and output the encoded data structure.

According to some embodiments, which can be combined with other embodiments described herein, the encoded data structure further includes at least a part of decoding information for decoding the encoded representation.

According to some embodiments, which can be combined with other embodiments described herein, the one or more processors of the data processing system are configured to perform the computer-implemented method for generating an encoded data structure according to the embodiments described in this document.

According to some embodiments, which can be combined with other embodiments described herein, the data processing system for generating an encoded data structure includes, or is, an encoder configured to perform the computer-implemented method for generating an encoded data structure according to the embodiments described in this document.

According to another independent aspect of the present disclosure, a computer program is provided. The computer program has instructions which, when the program is executed by a computer, cause the computer to carry out the method for generating an encoded data structure according to the embodiments described in this document.

According to another independent aspect of the present disclosure, a computer-readable storage medium is provided. The computer-readable storage medium has instructions which, when the program is executed by a computer, cause the computer to carry out the method for generating an encoded data structure according to the embodiments described in this document.

According to another independent aspect of the present disclosure, a computer-implemented method for decoding an encoded data structure is provided. The method includes receiving an encoded data structure, the encoded data structure including a plurality of data elements encoding a representation of uncertainty distribution information of a data set, and at least a part of decoding information for decoding the encoded representation; applying, based on the decoding information, a decoding algorithm to the encoded data structure to generate an uncertainty representation from the plurality of data elements; and outputting at least the uncertainty representation.

According to some embodiments, which can be combined with other embodiments described herein, the generated uncertainty representation is a direct mapping of the representation encoded in the plurality of data elements.

According to some embodiments, which can be combined with other embodiments described herein, the generated uncertainty representation is different from a direct mapping of the representation encoded in the plurality of data elements.

According to some embodiments, which can be combined with other embodiments described herein, the encoded data structure is configured according to the embodiments described in this document.

According to another independent aspect of the present disclosure, a data processing system for decoding an encoded data structure is provided. The data processing system includes one or more processors configured to receive an encoded data structure, the encoded data structure including a plurality of data elements encoding a representation of uncertainty distribution information of a data set, and at least a part of decoding information for decoding the encoded representation; apply, based on the decoding information, a decoding algorithm to the encoded data structure to generate an uncertainty representation from the plurality of data elements; and output at least the uncertainty representation.

According to some embodiments, which can be combined with other embodiments described herein, the one or more processors of the data processing system are configured to perform the computer-implemented method for decoding an encoded data structure according to the embodiments described in this document.

According to some embodiments, which can be combined with other embodiments described herein, the data processing system for decoding an encoded data structure includes, or is, a decoder configured to perform the computer-implemented method for decoding an encoded data structure according to the embodiments described in this document.

According to another independent aspect of the present disclosure, a computer program is provided. The computer program has instructions which, when the program is executed by a computer, cause the computer to carry out the method for decoding an encoded data structure according to the embodiments described in this document.

According to another independent aspect of the present disclosure, a computer-readable storage medium is provided. The computer-readable storage medium has instructions which, when the program is executed by a computer, cause the computer to carry out the method for decoding an encoded data structure according to the embodiments described in this document.

According to another independent aspect of the present disclosure, an encoded data structure is provided.

According to some embodiments, which can be combined with other embodiments described herein, the encoded data structure is configured according to the embodiments described in this document.

### BRIEF DESCRIPTION OF THE DRAWINGS

So that the manner in which the above recited features of the present disclosure can be understood in detail, a more particular description of the disclosure, briefly summarized above, may be had by reference to embodiments. The accompanying drawings relate to embodiments of the disclosure and are described in the following:
- FIG. 1: illustrates a schematic view of a conventional processor unit;
- FIG. 2: illustrates a schematic view of a processor unit according to embodiments of the present disclosure;
- FIG. 3: shows an overview of uncertainty tracking according to embodiments of the present disclosure;
- FIG. 4: illustrates the construction of an uncertainty representation using Telescoping Torques Representation (TTR) according to embodiments of the present disclosure;
- FIG. 5: illustrates a bit-level layout of an uncertainty representation according to embodiments of the present disclosure;
- FIG. 6: illustrates an encoded data structure according to embodiments of the present disclosure;
- FIG. 7: illustrates an encoded data structure according to further embodiments of the present disclosure;
- FIG. 8: illustrates a file to which an encoded data structure according to embodiments of the present disclosure can be added;
- FIG. 9: illustrates a file to which an encoded data structure according to embodiments of the present disclosure has been added;
- FIG. 10: illustrates a flow chart of a computer-implemented method for generating an encoded data structure according to embodiments of the present disclosure;
- FIG. 11: illustrates a flow chart of a computer-implemented method for decoding an encoded data structure according to embodiments of the present disclosure;
- FIGs. 12A-C: illustrate a system arrangement according to embodiments of the present disclosure; and
- FIGs. 13A-C: illustrate another system arrangement according to embodiments of the present disclosure.

### DETAILED DESCRIPTION OF EMBODIMENTS

Reference will now be made in detail to the various embodiments of the disclosure, one or more examples of which are illustrated in the figures. Within the following description of the drawings, the same reference numbers refer to same components. Generally, only the differences with respect to individual embodiments are described. Each example is provided by way of explanation of the disclosure and is not meant as a limitation of the disclosure. Further, features illustrated or described as part of one embodiment can be used on or in conjunction with other embodiments to yield yet a further embodiment. It is intended that the description includes such modifications and variations.

This document includes references to "one embodiment" or "an embodiment". The appearances of the phrases "in one embodiment" or "in an embodiment" do not necessarily refer to the same embodiment. Particular features, structures, or characteristics may be combined in any suitable manner consistent with this disclosure.

The term "comprising" is open-ended. As used in the appended claims, this term does not foreclose additional structure or steps.

Various units, circuits, or other components may be described or claimed as "configured to" perform a task or tasks. In such contexts, "configured to" is used to connote structure by indicating that the units/circuits/components include structure (e.g., circuitry) that performs those task or tasks during operation. As such, the unit/circuit/component can be said to be configured to perform the task even when the specified unit/circuit/component is not currently operational (e.g., is not on). The units/circuits/components used with the "configured to" language include hardware for example, circuits, memory storing program instructions executable to implement the operation, etc. Additionally, "configured to" can include generic structure (e.g., generic circuitry) that is manipulated by software and/or firmware (e.g., an FPGA or a general-purpose processor executing software) to operate in manner that is capable of performing the task(s) at issue.

As used herein, the terms "first", "second", etc. are used as labels for nouns that they precede, and do not imply any type of ordering (e.g., spatial, temporal, logical, etc.).

As used herein, the term "based on" is used to describe one or more factors that affect a determination. This term does not foreclose additional factors that may affect a determination. That is, a determination may be solely based on those factors or based, at least in part, on those factors. Consider the phrase "determine A based on B." While in this case, B is a factor that affects the determination of A, such a phrase does not foreclose the determination of A from also being based on C. In other instances, A may be determined based solely on B.

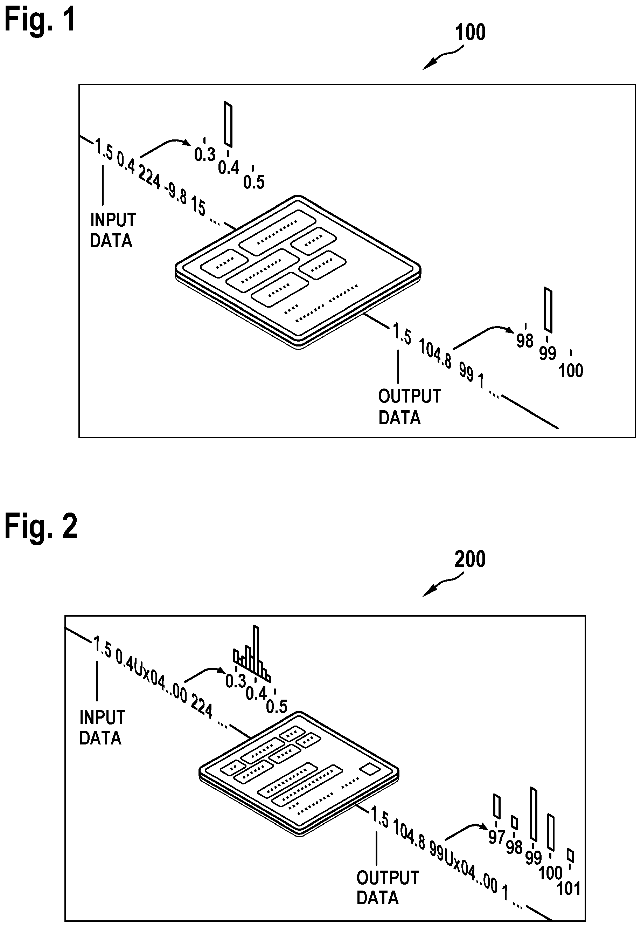

FIG. 1 illustrates a schematic view of a conventional processor unit 100.

A conventional processor unit 100 takes as input integer and floating-point values and performs operations (e.g., ADD, SUBSTRACT, MULTIPLY, XOR, etc.) on these data. The results of these operations are other integers or floating-point values.

Uncertainties in input data such as readings from sensors or stock market data are not uncommon, but the conventional processor unit 100 can only deal with integer and floating-point values which are certain and unambiguous. Therefore, the software running over the conventional processor unit 100 eliminates the uncertainties by averaging the variations across readings into a single number, to get the data into a form that the conventional processor unit 100 can handle, before feeding the averaged data into subsequent steps.

However, in many cases, the accuracy of the processing result is critical. For example, if an autonomous control algorithm of a driverless car must perform an emergency stop, the uncertainties in the sensor data may affect whether the emergency stop is performed in a safe manner. In such safety-critical use cases, so-called Monte Carlo methods can be employed, which involve re-running software millions of times with slightly different inputs, according to the distributions of the input uncertainties, to understand how uncertainties in the inputs could affect results. However, Monte Carlo methods are slow and expensive and only feasible for use in offline analyses.

FIG. 2 illustrates a schematic view of a processor unit 200 according to embodiments of the present disclosure.

The processor unit 200 of the present disclosure can take in as input the same kinds of integer and floating-point values and perform the same kinds of operations (e.g., ADD, SUBSTRACT, MULTIPLY, XOR, etc.) as the conventional processor unit. In addition to that, the values taken as input include additional information about distributions associated with each value, and the processor unit 200 may also, in some embodiments, enable a number of additional operations that act on the distribution information (e.g., BAYESLAPLACE, DISTFROMSAMPLES, etc.).

The input, in particular the distribution information, is in the form of an encoded data structure, which will be described later.

In some embodiments, the processor unit 200 of the present disclosure can be implemented as a virtualization layer. By moving uncertainty tracking into a virtualization layer below the user's software, applications can be significantly simplified. Furthermore, the implementation of the processor unit 200 as a virtualization layer means users can benefit from advances in the technology as it evolves, without needing to rewrite the user's software.

Embodiments of the uncertainty tracking technology are described in detail below.

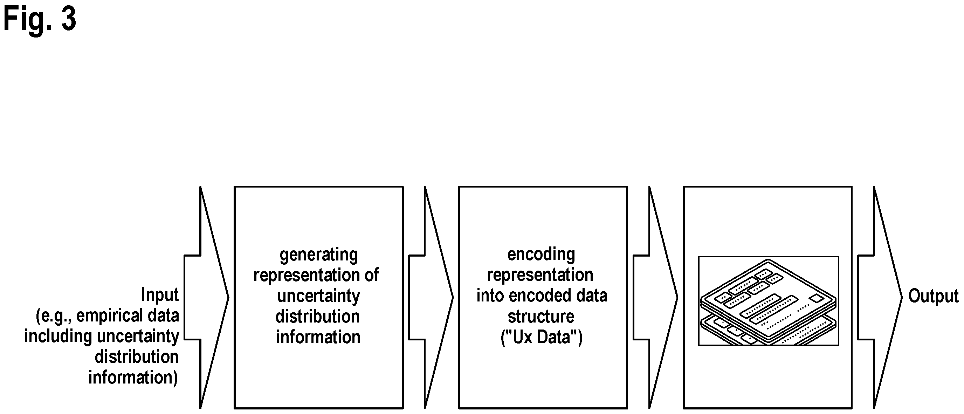

FIG. 3 shows an overview of uncertainty tracking according to embodiments described herein.

The processor unit of the present disclosure keeps track of uncertainty distributions paired with all data it processes, without requiring any changes to a software which runs on the processor unit. The processor unit is able to do this by employing an encoded data structure developed by the applicant.

The encoded data structure is generated based on a real-world data set, which is also referred to as input data. In some embodiments, the data set includes, or is, a set of samples. The set of samples may be a set of empirical samples, such as a set of sensor readings. In general, a sample is understood as an item of a corresponding set of measurements of a quantity of interest, the so-called measurand. The measurement may be, for example, a sensor reading, such as an acceleration, a magnetic flux density or a LiDAR reading.

When a quantity of interest is measured, the result depends on the measurement system, the measurement method, the skill of the operator, the environment, and other influences. Even if the quantity of interest were measured several times in the same way and under the same circumstances, a different measurement value would generally be obtained each time. The scatter of the measurement values (uncertainty distribution) would refer to how well the measurement was performed.

Although the data set has been described above in the context of a set of empirical samples, it is to be understood that the present disclosure is not limited thereto and that the data set may include, or be, a common analytic distribution.

The data set is first processed to generate a representation of the uncertainty distribution. Then, this representation is transformed (or encoded) into an encoded data structure, also referred to as "Ux Data". Encoding the data has the benefit that the encoded data structure can be transmitted efficiently and with reduced communication resources, e.g., via a mobile network. The processor unit of the present disclosure can take as input the Ux Data, decode the Ux Data to generate a representation of the uncertainty distribution (e.g., the same representation as encoded or a different representation based on the encoded representation), and perform operations on the uncertainty distribution information obtained from the Ux Data.

### Uncertainty distribution representations

Non-limiting methods for representing uncertainty distributions in digital form are explained below.

The data set, such as a set of empirical data or an analytic distribution, is first processed to generate a representation of the uncertainty distribution of the data set (also referred to as "uncertainty representation"). In preferred embodiments of the present disclosure, the uncertainty representation is a representation of probability mass/density functions/distributions on which a processor unit (e.g., the processor unit 200 shown in FIG. 2) can operate. In the same way that each value of a floating-point register is an approximate representation of a real-valued number, a value in the uncertainty representation is an approximation of an entire probability mass function.

A representation generation algorithm can be used to generate the representation of the uncertainty distribution information from the data set. In some embodiments, two or more parameters can be used to construct the uncertainty representation from the data set, i.e., a distribution of data items.

In preferred embodiments, the representation generation algorithm can be configured to generate the uncertainty representation according to a position parameter and a probability parameter, wherein each position of the uncertainty representation is represented by a Dirac delta associated with a corresponding probability mass. In other words, each real number in the domain of a distribution may be described by a Dirac delta with some probability mass located at the value of the real number.

It should be noted that this representation of a distribution in terms of Dirac deltas within its domain is different from that of a probability mass function (PMF), where the domain of the distribution is by definition discrete-valued and integrals can be replaced with sums. Because the Dirac delta distribution is not a function but rather is a distribution, the representation of distributions as a collection of Dirac deltas is also different from the concept of a probability density function (PDF). In general, one can call a representation made up of Dirac deltas that integrate to 1.0 (i.e., their probability masses sum up to 1.0) as probability density distribution (PDD) which is a generalization of a probability density function (PDF) (i.e., a PDF is a PDD but not vice versa).

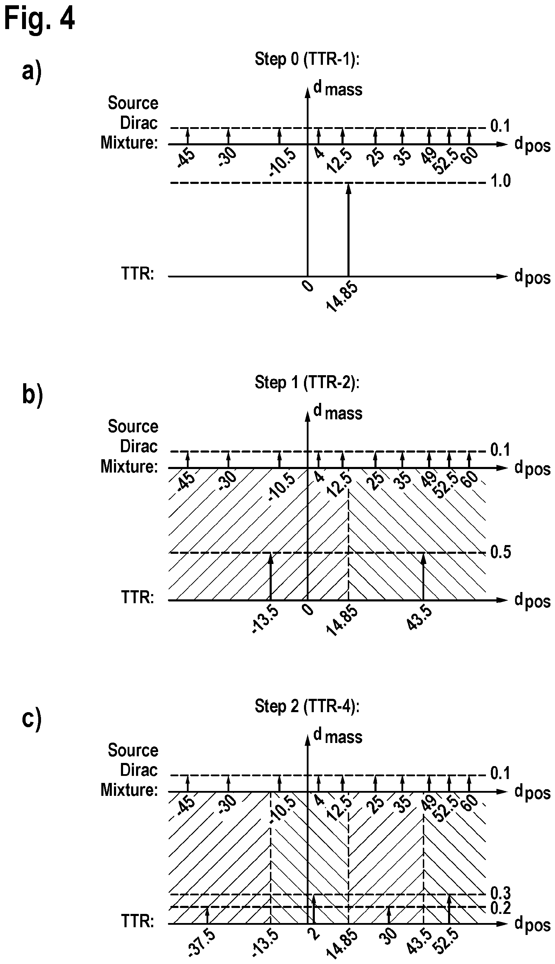

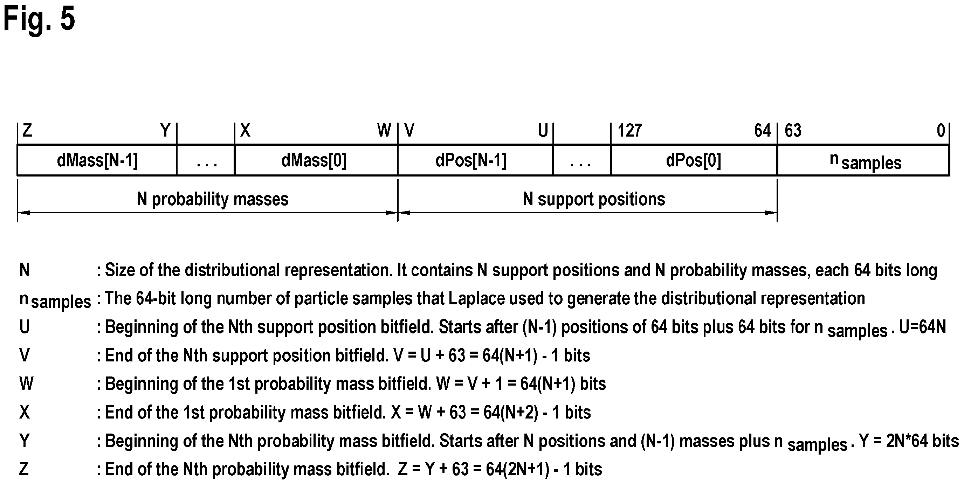

The so-called Telescoping Torques Representation (TTR) is described below with reference to FIGs. 4 and 5 as an example of an uncertainty representation of a distribution in terms of Dirac deltas. It is to be understood that the present disclosure is not limited thereto and that other methods may also be used to construct representations, such as Moment-Quantized Histogram Representation (MQHR) described in WO 2022/248714 A1.

The Telescoping Torques Representation (TTR) builds on Dirac mixture representation and is based on the intuition that the mean value of a set of samples splits the samples into two sets with equal products of the distance of the sample from the mean and the sample probability. This allows the representation to capture the effects of unlikely, yet high-value samples even at small representation sizes.

Let *src_{DM}* be a Dirac mixture of samples from a random variable *X.* Let *N* be a positive integer power of two. *src_{DM}* is converted to a distribution representation of size *N* using a recursive conversion algorithm of *log₂ N* steps. The number of steps is what is referred to as the "order" of the distribution representation. At each step, the algorithm splits a source Dirac mixture on its mean value *m,* creating two Dirac mixtures, which are the inputs of two new calls to the algorithm.

FIG. 4 illustrates an example for *N* = 4, starting from a *src_{DM}* of 10 particles. The top part of FIG. 4 illustrates the source Dirac mixture. The mixture consists of 10 Dirac deltas, each one positioned at the value of each unique source sample. The mass of each Dirac delta is 0.1, equal to the relative frequency of each particle sample.

In step 0 of FIG. 4(a), the conversion algorithm creates the zeroth-order distribution representation of *src_{DM},* which is a single Dirac delta located at the mean (*m* = 14.85) of *src_{DM}* (*i.e., dₚₒₛ*[0] = 14.85) with probability mass equal to the sum of the probability masses of all Dirac deltas in *src_{DM}* (*dₘₐₛₛ*[0] = 1.0).

In step 1 of FIG. 4(b), the conversion algorithm splits *src_{DM}* into two mixtures (each with five Dirac deltas in this example) using *m* as a boundary, and repeats the process for each sub-mixtures. FIG. 4(b) illustrates the first-order distribution representation of *src_{DM},* which has two Dirac deltas positioned at the mean value of the Dirac mixture splits of step 0, each one with probability mass equal to 0.5.

In step 2 of FIG. 4(c), the conversion process repeats, further splitting the sub-mixtures of step 1, into two parts. This results in four sub-mixtures and four Dirac deltas that represent them and form the second-order distribution representation of *src_{DM}.* FIG. 4(c) illustrates that the split in step 1 results in sub-mixtures that each contain a different number of source particle samples. Step 2 represents these sub-mixtures with Dirac deltas with unequal probability masses. FIG. 4(c) illustrates that the outcome Dirac deltas retain the property of equal probability torque on the two sides of the mean value of the source Dirac mixture (*m* = 14.85).

A Dirac mixture requires only a series of positions *xᵢ* and probability masses *pᵢ* for its description. For a random variable *d,* its Dirac mixture of size *N* is an array of 2*N* floating-point values. For the ith Dirac delta of the mixture, the position *dₚₒₛ*[*i*] and probability mass *dₘₐₛₛ*[*i*] are stored.

FIG. 5 illustrates a one bit-level layout for such a Dirac mixture. The set of bits in the layout allow a concise in-processor representation for any probability distribution, whether it is an empirical distribution or a (parametric) nameable distribution such as an exponential distribution or a Gaussian distribution.

The above sum-of-Dirac-deltas representation may be described in the form of a set of tuples (i.e., a set of *n k*-tuples). A reference herein to a "tuple" may be considered to include a reference to a data structure consisting of multiple parts defining an ordered set of data constituting a record, as is commonly understood in the art. In mathematics, a tuple is a finite sequence of elements such as a sequence of *k* elements, where k is a non-negative integer (e.g., *k*=2)*.*

In a preferred embodiment of the present disclosure, each tuple of the set of tuples is a real or integer value (i.e., the position parameter) paired with a probability (i.e., the probability mass, which is a real number between 0 and 1), and the probabilities in the set of tuples add up to 1. Accordingly, each tuple provides a data structure within which distributional information is encoded. These tuples are distinct from the probability distribution itself.

Tuples other than those described above may be used in further embodiments. For example, (*m*+1)-tuples could be defined where the first *m* numbers tell the m-dimensional position of a Dirac delta, and the last number is the probability mass of the Dirac delta.

The present disclosure is not limited to the above sum-of-Dirac-deltas representation, and other uncertainty representations can be constructed from the real-world data set. Another example of such an uncertainty representation is an interval-based representation (i.e., a piecewise constant approximation of the probability density function, which is equivalent to the linear approximation of the CDF) having n intervals and k = 3 (start of interval, end of interval, density value).

Yet another example is a mixture of these, e.g., consider a distribution density with half of its mass in a uniform [0, 1] (thus, exactly represented by the 3-tuple (0, 1, 0.5)) and the other half is degenerate at the value 2 (thus, exactly represented by the 2-tuple (2, 0.5)). A degenerate distribution can be understood as a probability distribution that has a non-trivial probability mass (i.e., greater than 0) concentrated in a lower dimensional manifold than the dimension of the range of the corresponding random variable (a.k.a., the domain of the distribution). In particular, any 1-dimensional PDD that contains a Dirac delta with probability mass greater than 0 is a degenerate distribution (which has nontrivial mass concentrated at a point, a 0-dimensional manifold).

The uncertainty representations described above make it unnecessary to generate large numbers of samples in order to sample the tails of a distribution (i.e., to converge) in the terminology of Monte Carlo methods. In particular, the Ux representation (and subsequent computation using it) makes irrelevant the whole idea of having to keep running Monte Carlo iterations until one has sampled far enough out into the tails (of the inputs as well as of the results). The uncertainty representation is therefore more efficient to transmit and also makes computation on this uncertainty representation yield better results. Most importantly, for distributions where one is able to create the representation from the analytic form, it removes the need, during computation, for repeatedly sampling until the probability of having sampled in the tails of the distribution has reached some threshold (convergence).

### Encoded data structures (Ux Data)

Non-limiting examples of encoded data structures are described below.

The encoded data structure of the present disclosure is based on the representation of the uncertainty distribution information (probability distributions), and therefore makes computations on distributions efficient. It exploits the mathematics of probability distributions to make possible uncertainty quantification that no longer needs to make significant time-versus-correctness tradeoffs and convergence challenges of traditional sampling-based uncertainty quantification. With the encoded data structure of the present disclosure, computing systems no longer need to make the false choice between speed (time to reach an answer) and convergence (e.g., how many standard deviations out from the expected value the uncertainty quantification has sampled, e.g., 3-sigma or 6-sigma).

The encoded data structure of the present disclosure represents a transmission or interchange format, which could be either as a Unicode or ASCII string ("Ux String"), as a generic sequence of binary bits ("Ux Binary"), or the information could be incorporated into the structure of a file ("Ux File"), or the information could be incorporated into an operating system's metadata register ("Ux Metadata").

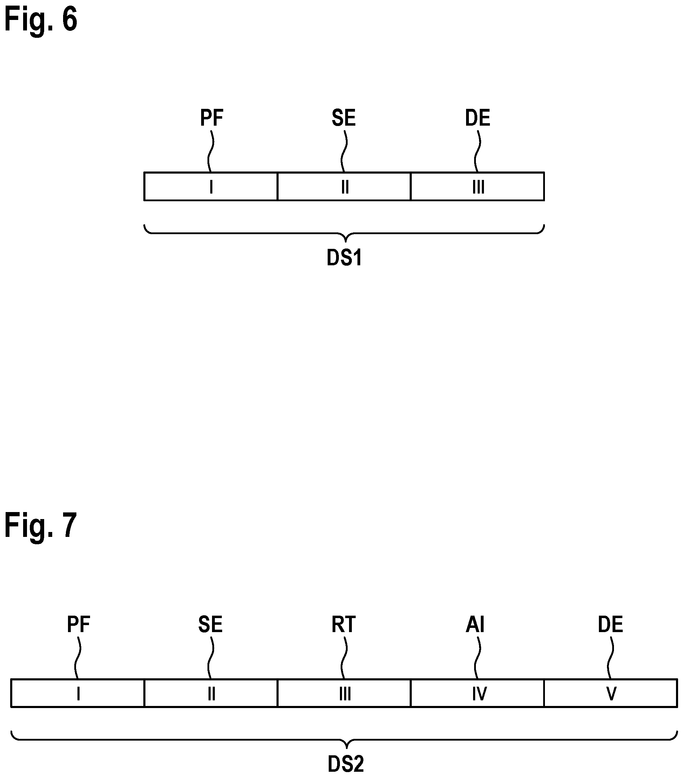

FIG. 6 illustrates an encoded data structure DS1 according to embodiments of the present disclosure.

The encoded data structure DS1 is shown as a string having a plurality of fields, each containing specific information. As shown in FIG. 6, in a preferred embodiment, the encoded data structure DS1 may include at least three fields I, II and III.

The first field I contains a numerical prefix PF, the second field II contains a separator SE, and the third field III contains the plurality of data elements DE that encode the uncertainty representation. Accordingly, the encoded data structure DS1 contains (ordered from the left to the right) at least the numerical prefix PF, the separator SE, and the plurality of data elements DE.

The numerical prefix PF can be a traditional value with no uncertainty, such as a particle value. In particular, computer architectures today represent uncertain values with single point values or particle values (i.e., data with no associated uncertainty distribution), usually by taking the mean value as the representation for use in computation. The particle value can be any known numerical representation, not just integer and floating-point representations. In particular, the particle value can contain any permissible number of characters for representing a number in a computer system (i.e., the particle value not fixed in size).

The separator SE can be configured so that a (conventional) computer architecture recognizes that it has reached the end of a number, and as a result will only consider the number part of the encoded data structure (i.e., the numerical prefix PF). For example, the separator SE can be any fixed string that serves as a delimiter which a computer system reading in the string will recognize as being a non-numeric value (e.g., "Ux"). This allows the encoded data structure of the present disclosure to be deployed in a backwards-compatible manner in legacy systems.

The plurality of data elements DE in the third field III encodes the uncertainty representation, i.e., the representation of the uncertainty distribution information of the real-world data set, such as empirical or analytic data. The representation encoded in the plurality of data elements DE may be in the form of a set of n-tuples, but other forms of representation are also possible. In some embodiments, each tuple of the set of tuples is a real or integer value (e.g., a position parameter) paired with a probability (i.e., a probability mass), and the probabilities in the set of tuples add up to 1, but the present disclosure is not limited to such 2-tuples and other *n*-tuples could be defined.

The plurality of data elements DE is configured to allow a representation of the uncertainty distribution information to be reconstructed therefrom. The reconstructed representation may be the same representation as the encoded representation (e.g., a direct mapping of the encoded tuples) or a more sophisticated representation.

The encoded data structure DS1 may include decoding information for decoding the encoded representation. In some embodiments, at least a part of the decoding information is encoded in the plurality of data elements DE. In particular, the encoded data structure DS1 may be self-describing, at least to some extent, for a system to be able to decode it.

Additionally, or alternatively, at least a part of the decoding information is provided separately from the plurality of data elements, e.g., in one or more additional fields of the encoded data structure (not shown; see FIG. 7).

Additionally, or alternatively, at least a part of the decoding information required to decode the encoded data structure is provided by an external source, i.e., not by the encoded data structure itself. For example, a system decoding the encoded data structure may already have at least some information that allows access to the information contained in the encoded data structure.

FIG. 7 illustrates an encoded data structure DS2 according to further embodiments of the present disclosure.

The encoded data structure DS2 is shown as a string having a plurality of fields, each containing specific information. As shown in FIG. 7, in a preferred embodiment, the encoded data structure DS2 may include at least five fields I, II, III, IV and V.

The first field I contains a numerical prefix PF, the second field II contains a separator SE, the third field III contains a representation type RT, the fourth field IV contains auxiliary information AI, and the fifth field V contains the plurality of data elements DE that encode the uncertainty representation. Accordingly, the encoded data structure DS2 contains (ordered from the left to the right) at least the numerical prefix PF, the separator SE, the representation type RT, the auxiliary information AI, and the plurality of data elements DE.

The numerical prefix PF can be a traditional value with no uncertainty, such as a particle value. In particular, computer architectures today represent uncertain values with single point values or particle values (i.e., data with no associated uncertainty distribution), usually by taking the mean value as the representation for use in computation. The particle value can be any known numerical representation, not just integer and floating-point representations. In particular, the particle value can contain any permissible number of characters for representing a number in a computer system (i.e., the particle value not fixed in size).

The separator SE can be configured so that a (conventional) computer architecture recognizes that it has reached the end of a number, and as a result will only consider the number part of the encoded data structure (i.e., the numerical prefix PF). For example, the separator SE can be any fixed string that serves as a delimiter which a computer system reading in the string will recognize as being a non-numeric value (e.g., "Ux"). This allows the encoded data structure of the present disclosure to be deployed in a backwards-compatible manner in legacy systems.

The third field III specifies the representation type RT (e.g., sum-of-Dirac-deltas representation or interval-based representation) and determines how to decode the subsequent fields.

The fourth field IV may be any auxiliary information AI related to the plurality of data elements DE (distribution data) in the fifth field V. Examples of data in the fourth field IV include, but are not limited to, a number of samples, a mean value of the distribution, and a number of non-zero mass Dirac deltas for Dirac mixture distributions. The size of the fourth field IV may be determined by the representation type indicated in the third field III). The fourth field IV may also contain statistics (e.g., mean, standard deviation, curtosis, etc.) of the distribution described in the fifth field V, and/or other metadata.

The fifth field V holds the plurality of data elements DE, i.e., distribution data. The interpretation of the distribution data in the fifth field V is determined by the representation type RT in the third field III. Examples of information to be placed in the fifth field V include, but are not limited to:
- A sum-of-Dirac-deltas representation with *k* = 2 (i.e., a set of *n* 2-tuples).
- An interval-based representation (i.e., a piecewise constant approximation of the probability density function, which is equivalent to the linear approximation of the CDF), having n intervals and *k* = 3 (start of interval, end of interval, density value).
- A mixture of these, e.g., consider a distribution density with half of its mass is in a uniform [0, 1] (thus, exactly represented by the 3-tuple (0, 1, 0.5)) and the other half is degenerate at the value 2 (thus, exactly represented by the 2-tuple (2, 0.5)).

The design of the encoded data structures described above is such that many legacy systems that can ingest integer and floating-point numbers (e.g., ASCII or UTF-8 strings that represent a number), will interpret the encoded data structure as a number (i.e., as the particle value in the first field I), thanks to the delimiting separator SE in the second field II. For example, on a Unix-based system, while processing the encoded data structure using routines such as scanf in the standard C library, a computing system will identify it has reached the end of a number in its input when it reaches the character "U" of separator "Ux" and as a result will only consider the number part of it (i.e., the particle value in the first field I).

In addition, the encoded data structures described above contain information that allows a system to decode it (i.e., is self-describing and, depending on the representation type, extensible in terms of number of Dirac deltas), and the format leads to the possibility of more efficient representation of distributions and more efficient computation on distributions. And, even though the representation exploits the underlying mathematics of representations, the key idea is that it is in a form that can be implemented by an automated mechanism like in a processor.

The encoded data structure described above may be in various formats, a few and non-limiting embodiments of which are explained below, namely an ASCII string ("Ux String"), a sequence of binary bits ("Ux Binary"), and a file ("Ux File"). Further encodings of Ux Data types are possible, such as a compression of a Ux String.

### Ux String

The format "Ux String" begins with a number (particle value), followed by Ux (separator), followed by a hexadecimal string (plurality of data elements):

The number at the beginning (0.785398) provides traditional point-valued or particle numerical information. The hexadecimal string (0400...0000) provides uncertainty distribution information associated with that number. The separator (Ux) is a non-numeric value that precedes the hexadecimal string and separates the hexadecimal string from the particle value.

In some embodiments, each digit of the hexadecimal string following the separator Ux corresponds to one data element of the plurality of data elements. In other embodiment, a subset of digits of the hexadecimal string correspond to one data element of the plurality of data elements. A subset of digits may correspond to one field of the data structure or to a particular type of information of the data structure (see also the following examples: number of samples, mean value of distribution, etc.).

In case of a sum-of-Dirac-deltas representation, in a preferred embodiment, the format "Ux String" may contain at least the following:
- particle value
- separator "Ux" (2 ASCII characters)
- representation type (hexadecimal value as two ASCII characters)
- number of samples (hexadecimal value as 16 ASCII characters)
- mean value of distribution (hexadecimal value as 16 ASCII characters)
- number of non-zero mass Dirac deltas (hexadecimal value as 8 ASCII characters)
- sequence of n pairs of (a) support position (hexadecimal value as 16 ASCII characters); (b) probability mass (hexadecimal value as 16 ASCII characters)

### Ux Binary

At the level of binary representation, the encoded data structure begins with a number (particle value), followed by a separator (Ux), followed by uncertainty distribution information (plurality of data elements):

The first 64 binary digits are the 64-bit representation of 0.785398 (particle value) in the IEEE-754 format. The next two sets of 8 bits are the two-byte representations of ASCII "Ux" (separator). The last group of binary digits is the hexadecimal string for 0400...0000 of the previous example, converted to binary.

In some embodiments, each digit of the binary representation following the separator Ux corresponds to one data element of the plurality of data elements. In other embodiment, a subset of digits of the binary representation corresponds to one data element of the plurality of data elements. A subset of digits may correspond to one field of the data structure or to a particular type of information of the data structure (see also the following examples: number of samples, mean value of distribution, etc.).

In case of a sum-of-Dirac-deltas representation, in a preferred embodiment, the format "Ux Binary" may contain at least the following:
- particle value
- separator "Ux" (2 ASCII characters)
- representation type (8 bits)
- number of samples (64 bits)
- mean value of distribution (64 bits)
- number of non-zero mass Dirac deltas (32 bits)
- sequence of n pairs of (a) support position (64 bits); (b) probability mass (64 bits)

### Ux File

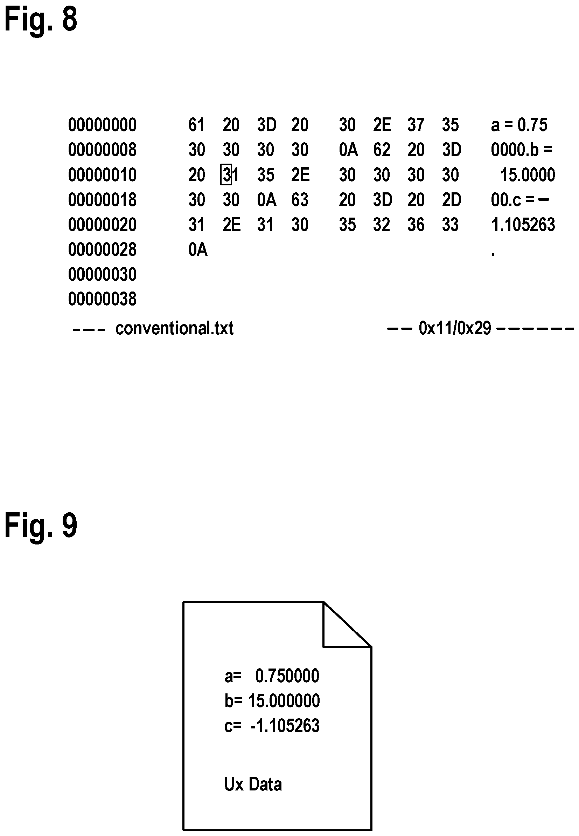

FIG. 8 illustrates a conventional file to which an encoded data structure according to embodiments of the present disclosure can be added. FIG. 9 illustrates a file to which an encoded data structure according to embodiments of the present disclosure has been added.

In some embodiments, the Ux information is spread across a file. In particular, a main body of the file contains a number (e.g., the particle value "0.75") and the end of the file has a table/index indicating which byte offset in the main file the entry is referring to (e.g., the byte offset of the "0.75"), followed by the Ux Data.

The uncertainty information can be byte-offset as string data:
a = 0.750000
b = 15.000000
c = -1.105263

The first three lines are the contents of the normal file (see FIG. 8) and the line starting at "0x5:..." is the table/index referred to above.

Alternatively, the uncertainty information can be byte-offset as binary data (only the postlude is shown as binary data):
a = 0.750000
b = 15.000000
c = -1.105263

The first three lines are the contents of the normal file (see FIG. 8) and the line starting at "05 55..." is the table/index referred to above.

In a conventional operating system, the operating system keeps metadata about a file (conventional *inode* information), such as a file size, a file mode, a user ID of the file owner, a timestamp for when the file was last modified, and which bytes in a physical storage medium are used to keep the contents of the file.

With a Ux File, in addition to the standard contents of the file, additional uncertainty information are stored in the file (e.g., the equivalent of the fields DE in FIG. 6 or the fields RT+AI+DE in FIG. 7). In some embodiments, the conventional *inode* information can be augmented with a field which gives the offset (in bytes) within the file where the uncertainty information is stored.

For Ux Files, the equivalent of the prefix field in Ux Strings is the existing file. Rather than a delimiter inserted into the data itself, embodiments of the present disclosure may instead use external metadata maintained by the operating system (stored in an *inode*) to specify where in the file the additional uncertainty information (e.g., the equivalent of the fields DE in FIG. 6 or the fields RT+AI+DE in FIG. 7) begin.

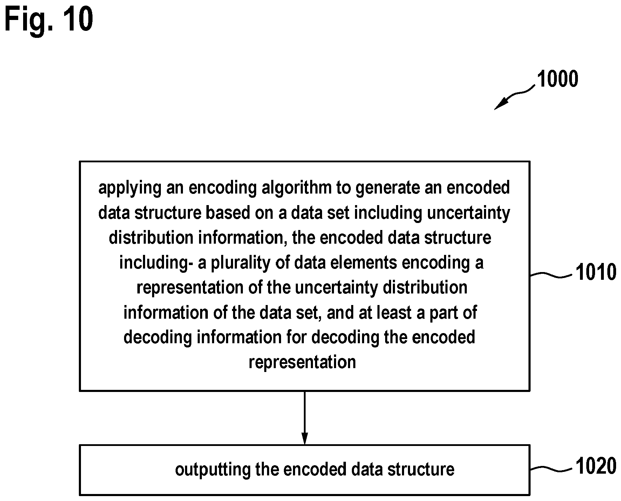

FIG. 10 illustrates a flow chart of a computer-implemented method 1000 for generating an encoded data structure according to embodiments of the present disclosure.

The computer-implemented method 1000 includes applying (block 1010) an encoding algorithm to generate an encoded data structure based on (a representation of) a data set including uncertainty distribution information, and outputting (block 1020) the encoded data structure. The encoded data structure includes a plurality of data elements encoding a representation of the uncertainty distribution information of the data set. Preferably, the encoded data structure further includes at least a part of decoding information for decoding the encoded representation.

According to some embodiments, which can be combined with other embodiments described herein, the encoded data structure is configured according to the embodiments described in this document.

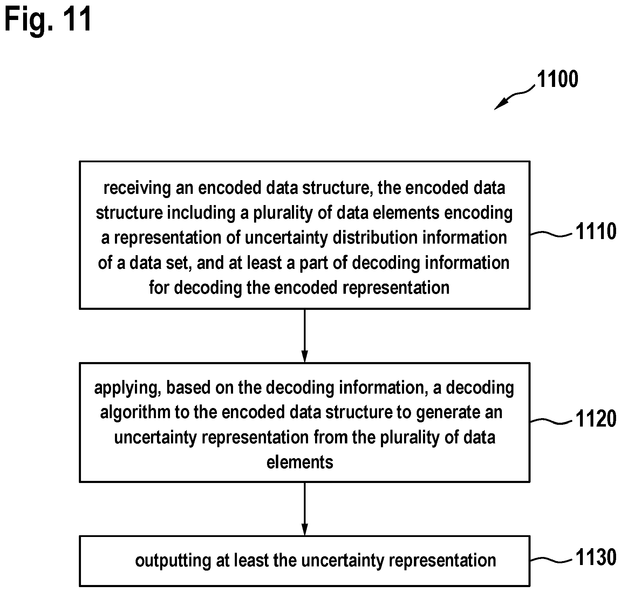

FIG. 11 illustrates a flow chart of a computer-implemented method 1100 for decoding an encoded data structure according to embodiments of the present disclosure.

The method 1100 includes receiving (block 1110) an encoded data structure, the encoded data structure including a plurality of data elements encoding a representation of uncertainty distribution information of a data set, and at least a part of decoding information for decoding the encoded representation; applying (block 1120), based on the decoding information, a decoding algorithm to the encoded data structure to generate an uncertainty representation from the plurality of data elements; and outputting (block 1130) at least the uncertainty representation.

According to some embodiments, which can be combined with other embodiments described herein, the encoded data structure is configured according to the embodiments described in this document.

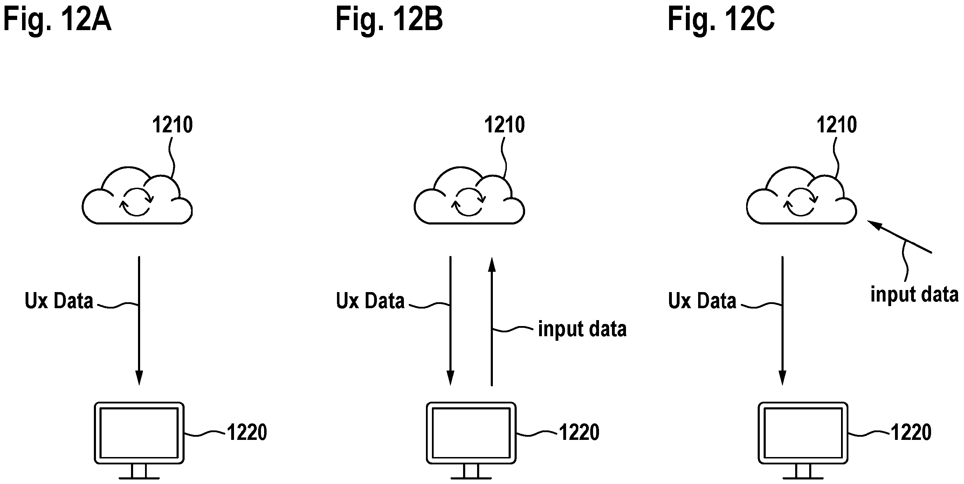

FIGs. 12A-C illustrate a system arrangement 1200 according to embodiments of the present disclosure.

The system arrangement 1200 includes a computing platform 1210, such as a cloud computing platform, and a client device 1220.

The computing platform 1210 is configured to generate the encoded data structure based on input data, such as real-world data. The input data may be provided by the client device 1220 (FIG. 12A) or by another external entity (FIG. 12B). The external entity can be, for example, another client device, a storage medium (e.g., USB stick or SD card), and the like. In some embodiments, the input data includes, or is, a set of samples. The set of samples may be a set of empirical samples, such as a set of sensor readings. However, the present disclosure is not limited to empirical data, and the input data may include or be a general analytic distribution.

The Ux data generated by the computing platform 1210 is then sent to the client device 1220 for further processing and/or rendering. Encoding the data before sending it to the client device 1220 has the benefit that the encoded data structure can be transmitted efficiently and with reduced communication resources, e.g., via a mobile network. The client device 1220 can take as input the Ux Data, decode the Ux Data to generate a representation of the uncertainty distribution (e.g., the same representation as encoded or a different representation based on the encoded representation), and perform operations on the uncertainty distribution information obtained from the Ux Data.

The computing platform 1210 and the client device 1220 may communicate via a transmission medium, such as a network. In one embodiment, the network is a mobile network. The transmission medium may use any of various wireless communication technologies, or telecommunication standards, such as GSM, UMTS, LTE, LTE-Advanced (LTE-A), 5G, HSPA, and the like.

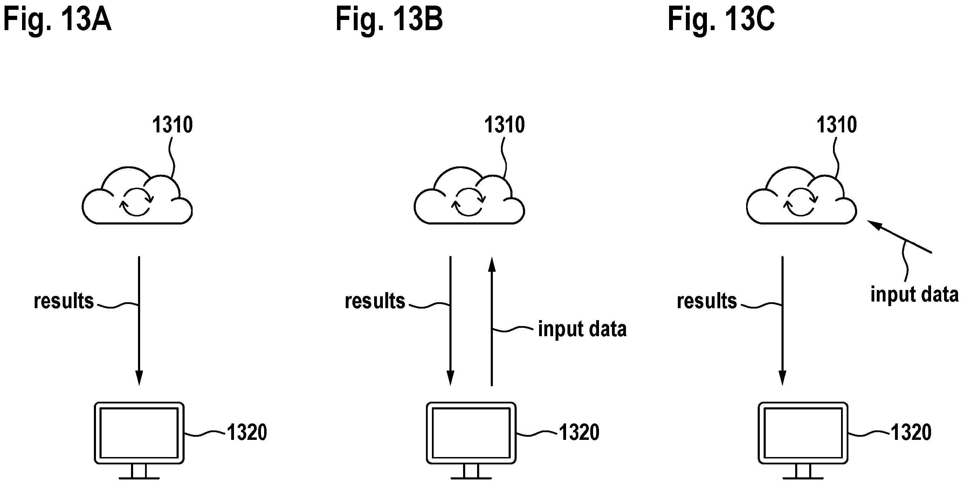

FIGs. 13A-C illustrate a system arrangement 1300 according to further embodiments of the present disclosure.

The system arrangement 1300 includes a computing platform 1310, such as a cloud computing platform, and a client device 1320. In the example of FIGs. 13A-C, the computing platform 1310 does all of the work and sends only the processing results to the client device 1320, e.g., for display, rendering, or finetuning.

The present disclosure is not limited to the above embodiments, and the method steps of the present disclosure, for example as illustrated in FIG. 3, may be performed on a single device/system/platform or on a distributed system having multiple interconnected entities.

The methods described herein may be implemented in software, hardware, or a combination thereof, in different embodiments. In addition, the order of the blocks of the methods may be changed, and various elements may be added, reordered, combined, omitted, modified, etc. Various modifications and changes may be made as would be obvious to a person skilled in the art having the benefit of this disclosure. The various embodiments described herein are meant to be illustrative and not limiting. Many variations, modifications, additions, and improvements are possible. Accordingly, plural instances may be provided for components described herein as a single instance. Boundaries between various components, operations and data stores are somewhat arbitrary, and particular operations are illustrated in the context of specific illustrative configurations. Other allocations of functionality are envisioned and may fall within the scope of claims that follow. Finally, structures and functionality presented as discrete components in the example configurations may be implemented as a combined structure or component. These and other variations, modifications, additions, and improvements may fall within the scope of embodiments as defined in the claims that follow.

## Claims

1. A computer-accessible medium having stored an encoded data structure, the encoded data structure comprising:
a plurality of data elements encoding a representation of uncertainty distribution information of a data set, and
at least a part of decoding information for decoding the encoded representation.

2. The computer-accessible medium of claim 1, the encoded data structure further including a numerical prefix and a separator preceding the plurality of data elements and separating the plurality of data elements from the numerical prefix, in particular wherein the numerical prefix is a particle value and/or the separator is a non-numeric separator.

3. The computer-accessible medium of claim 1 or 2, the encoded data structure further including representation type information and/or auxiliary information related to the representation, in particular wherein the auxiliary information includes at least one of:
- a number of samples,
- a mean value of distribution,
- a number of non-zero mass Dirac deltas,
- information about at least one algorithm used to generate the encoded data structure, and
- information about a decoding algorithm to be used to decode the encoded data structure.

4. The computer-accessible medium of any one of claims 1 to 3, wherein the plurality of data elements encodes a set of tuples defining the representation, wherein the set of tuples is a set of *k*-tuples, *k* being a positive integer ≥ 2, in particular wherein each tuple consists of a real value paired with a probability associated with the real value.

5. The computer-accessible medium of any one of claims 1 to 4, wherein at least the plurality of data elements is in the form of a hexadecimal string, or wherein the encoded data structure is in binary form, or wherein the encoded data structure is included in a file.

6. The computer-accessible medium of claim 5, wherein the file includes a main body containing the numerical prefix and a table or index indicating which byte offset in the main body the entry is referring to, followed by the plurality of data elements, in particular wherein the table or index is at an end of the file and/or the plurality of data elements in the file is provided in a binary form or as a hexadecimal string and/or information about the offset is stored in an operating system's metadata.

7. A computer-implemented method for generating an encoded data structure, comprising:
a) applying an encoding algorithm to generate an encoded data structure based on a data set including uncertainty distribution information, the encoded data structure including:
- a plurality of data elements encoding a representation of the uncertainty distribution information of the data set, and
- at least a part of decoding information for decoding the encoded representation; and
b) outputting the encoded data structure.

8. The computer-implemented method of claim 7, further including:
applying a representation generation algorithm to generate the representation of the uncertainty distribution information from the data set, in particular wherein:
- the representation generation algorithm is configured to generate the representation according to a position parameter and a probability parameter, wherein the representation generation algorithm is configured to generate the representation as a sum-of-Dirac-deltas representation, where each position of the representation is represented by a non-zero mass Dirac delta associated with a corresponding probability mass; and/or
- the representation generation algorithm includes, or is, a recursive conversion algorithm of *log₂ N* steps, where *N* is a size of the representation.

9. The computer-implemented method of claim 7 or 8, further including:
generating a set of tuples defining the uncertainty representation, wherein the set of tuples is a set of k-tuples, k being a positive integer ≥ 2.

10. The computer-implemented method of claim 9, wherein each k-tuple is a 2-tuple consisting of a real value and a probability associated with the real value, wherein the real value of a tuple indicates a position of a non-zero mass Dirac delta, and the probability is a probability mass corresponding to the non-zero mass Dirac delta of the tuple, in particular wherein the probabilities in the set of tuples add up to 1.

11. A data processing system for generating an encoded data structure, comprising one or more processors configured to:
a) apply an encoding algorithm to generate an encoded data structure based on a data set including uncertainty distribution information, the encoded data structure including:
- a plurality of data elements encoding a representation of the uncertainty distribution information of the data set, and
- at least a part of decoding information for decoding the encoded representation; and
b) output the encoded data structure.

12. A computer-implemented method for decoding an encoded data structure, comprising:
a) receiving an encoded data structure, the encoded data structure including:
- a plurality of data elements encoding a representation of uncertainty distribution information of a data set, and
- at least a part of decoding information for decoding the encoded representation;
b) applying, based on the decoding information, a decoding algorithm to the encoded data structure to generate an uncertainty representation from the plurality of data elements; and
c) outputting at least the uncertainty representation.

13. The computer-implemented method of claim 12, wherein:
the generated uncertainty representation is a direct mapping of the representation encoded in the plurality of data elements, or
the generated uncertainty representation is different from a direct mapping of the representation encoded in the plurality of data elements.

14. A data processing system for decoding an encoded data structure, comprising one or more processors configured to:
a) receive an encoded data structure, the encoded data structure including:
- a plurality of data elements encoding a representation of uncertainty distribution information of a data set, and
- at least a part of decoding information for decoding the encoded representation;
b) apply, based on the decoding information, a decoding algorithm to the encoded data structure to generate an uncertainty representation from the plurality of data elements; and
c) output at least the uncertainty representation.

15. A computer program comprising instructions which, when the program is executed by a computer, cause the computer to carry out the method of any one of claims 7 to 10, 12 and 13.

16. A computer-readable storage medium comprising instructions which, when the program is executed by a computer, cause the computer to carry out the method of any one of claims 7 to 10, 12 and 13.
